# EUROPEAN PATENT APPLICATION

(11) **EP 2 006 887 A2**
(43) Date of publication of application: **24.12.2008**
(21) Application number: 08009301.6
(22) Date of filing: 20.05.2008
(51) Int. Cl.: H01L 21/20, H01L 21/762, H01L 33/00, C30B 25/18

(54) **III-V Nitride semiconductor layer-bonded substrate and semiconductor device**

(30) Priority: 30.05.2007 JP 2007143922
(71) Applicant: Sumitomo Electric Industries, Ltd., Osaka-shi, Osaka 541-0041 (JP)
(72) Inventor: Hachigo, akihiro, Itami-shi Hyogo 664-0016 (JP)
(74) Representative: Grünecker, Kinkeldey, Stockmair & Schwanhäusser Anwaltssozietät

(57) **Abstract**

Affords III-V nitride semiconductor layer-bonded substrates from which semiconductor device of enhanced properties can be manufactured, and semiconductor devices incorporating the III-V nitride semiconductor layer-bonded substrates. The III-V nitride semiconductor layer-bonded substrate, in which a III-V nitride semiconductor layer and a base substrate are bonded together, is characterized in that thermal expansion coefficient difference between the III-V nitride semiconductor layer and the base substrate is 4.5 × 10⁻⁶ K⁻¹ or less, and in that the thermal conductivity of the base substrate is 50 W • m⁻¹ • K⁻¹ or more.

## Description

### BACKGROUND OF THE INVENTION

### Technical Field

The present invention relates to Group III-V nitride semiconductor layer-bonded substrates in which a III-V nitride semiconductor layer and a base substrate are bonded together, and to semiconductor devices incorporating such bonded substrates.

### Description of the Related Art

Semiconductor devices employing III-V nitride semiconductors are formed in different ways. In one method, a III-V nitride semiconductor epitaxial layer is formed by, for example, metalorganic chemical vapor deposition (MOCVD) or by molecular beam epitaxy (MBE) onto a nonnative substrate, such as an Si, SiC, or sapphire substrate, that differs from the III-V nitride semiconductor in chemical composition, but only slightly in coefficient of thermal expansion. In another method, onto a III-V nitride semiconductor substrate, a III-V nitride semiconductor epitaxial layer is formed by, for example, MOCVD or MBE.

Utilizing the nonnative substrate as a substrate for forming a III-V nitride semiconductor epitaxial layer, however, produces stress in the nonnative substrate due, principally, to difference in thermal expansion coefficient, and to lattice mismatch, between the nonnative substrate and the III-V nitride semiconductor epitaxial layer. The stress produced in the substrate can lead to substrate and semiconductor device warpage, which causes such problems as increase in dislocation density in the III-V nitride semiconductor epitaxial layer, occurrences of epitaxial layer exfoliation, and degradation of semiconductor device performance. Meanwhile, although utilizing a III-V nitride semiconductor substrate as a substrate for III-V nitride semiconductor epitaxial layer formation enables manufacturing semiconductor devices of enhanced properties-on account of their being no difference or only slight difference in thermal expansion coefficient, and of their being close lattice mismatch, between the III-V nitride semiconductor substrate and the III-V nitride semiconductor epitaxial layer-the very high cost of the III-V nitride semiconductor substrates has made the semiconductor devices built on the substrates disadvantageously expensive.

Therefore, as substrates for the formation of III-V nitride semiconductor epitaxial layers, low-cost materials on which semiconductor devices of favorable properties can be manufactured are being sought. Examples that have been proposed of such substrates include a substrate in which a thin layer of GaN-based III-V nitride semiconductor has been bonded to a base substrate having the thermal expansion coefficient close to, or higher than that of the III-V nitride semiconductor thin layer. (Cf. Int'l. App. Based Japanese Unexamined Pat. App. Pub. No. 2004-512688, for example.)

In Pat. App. Pub. No. 2004-512688, all that is discussed with regard to the bonded substrate is difference in coefficient of thermal expansion between the III-V nitride semiconductor layer and the base substrate. The reason why this patent reference focuses exclusively on difference in thermal expansion coefficient is that in manufacturing semiconductor devices, because growing by MOCVD or MBE an at least single-lamina III-V nitride semiconductor epitaxial layer onto a III-V nitride semiconductor layer-bonded substrate requires high-temperature processes at a level of 600°C to 1100°C, a significant difference in thermal expansion coefficient between the III-V nitride semiconductor layer and the base substrate will lead to incidents of exfoliation of, and/or cracking in the semiconductor layer bonded to the base substrate.

Minimal difference in thermal expansion coefficient between the III-V nitride semiconductor layer and the base substrate is not, however, the only property demanded of III-V nitride semiconductor layer-bonded substrates employed in semiconductor devices. In particular, in order to reduce the accumulation of heat in the III-V nitride semiconductor layer in manufacturing and in using the semiconductor devices, it is necessary to employ base substrates of high thermal conductivity. Pat. App. Pub. No. 2004-512688, however, fails to take this necessity into consideration.

### BRIEF SUMMARY OF THE INVENTION

An object of the present invention is to take into consideration not only the difference in thermal expansion coefficient between the III-V nitride semiconductor layer and the base substrate, but also the thermal conductivity of the base substrate, to make available both III-V nitride semiconductor layer-bonded substrates that enable manufacturing enhanced-performance semiconductor devices, and semiconductor devices including the III-V nitride semiconductor layer-bonded substrates.

One aspect of the present invention is a III-V nitride semiconductor layer-bonded substrate in which a III-V nitride semiconductor layer and a base substrate are bonded together, the bonded substrate being characterized in that the difference in thermal expansion coefficient between the III-V nitride semiconductor layer and the base substrate is 4.5 x 10⁻⁶ K⁻¹ or less, and the thermal conductivity of the base substrate is 50 W · m⁻¹ · K⁻¹ or more.

In a III-V nitride semiconductor layer-bonded substrate involving the present invention, as the III-V nitride semiconductor layer, a GaN layer can be utilized. Furthermore, the resistivity of the base substrate can be brought to 10 Ω · cm or less. Moreover, the principal component of the base substrate can be a metal containing at least whichever of Mo, W, or Ir. Alternatively, the principal component the base substrate can be at least whichever of AlN, Si, or SiC. Herein, "principal component" means a component of which 50 mol % or more is contained within the base substrate. In that regard, for example, the sum total of AlN, SiC and Si may be 50 mol % or more. Furthermore, the base substrate thermal conductivity can be made higher than the III-V nitride semiconductor layer thermal conductivity. The base substrate can also be composed of one material selected from the group consisting of Cu-Mo alloys, Cu-W alloys, Al-SiC composite materials, diamond, and diamond-metal composite materials. Moreover, in the base substrate, a plurality of layers can be laminated.

The present invention in another aspect is a semiconductor device having an at least single-lamina III-V nitride semiconductor epitaxial layer formed on the III-V nitride semiconductor layer-bonded substrate.

The present invention affords III-V nitride semiconductor layer-bonded substrates that enable manufacturing semiconductor devices of enhanced properties, and the semiconductor devices including the III-V nitride semiconductor layer-bonded substrates.

From the following detailed description in conjunction with the accompanying drawings, the foregoing and other objects, features, aspects and advantages of the present invention will become readily apparent to those skilled in the art.

### BRIEF DESCRIPTION OF THE SEVERAL VIEWS OF THE DRAWINGS

Fig. 1 is an outline sectional view representing one embodiment of a III-V nitride semiconductor layer-bonded substrate involving the present invention.

Fig. 2 is outline sectional views representing one embodiment mode illustrating a method of manufacturing a III-V nitride semiconductor layer-bonded substrate involving the present invention, wherein Fig. 2A represents a bonding step, and Fig. 2B represents a separating step.

Fig. 3 is outline sectional views representing another embodiment mode illustrating a method of manufacturing a III-V nitride semiconductor layer-bonded substrate involving the present invention, wherein Fig. 3A represents a hydrogen ion implanting step, Fig. 3B represents a bonding step, and Fig. 3C represents a separating step.

Fig. 4 is an outline sectional view illustrating one example of a substrate with an attached III-V nitride semiconductor epitaxial layer.

Fig. 5 is an outline sectional view illustrating one example of a base substrate in which a plurality of layers has been laminated.

Fig. 6 is outline sectional views representing still another embodiment illustrating a method of manufacturing a III-V nitride semiconductor layer-bonded substrate involving the present invention, wherein Fig. 6A represents a hydrogen-ion implanting step, Fig. 6B represents a bonding step, and Fig. 6C represents a separating step.

Fig. 7 is an outline sectional view representing one embodiment of a semiconductor device involving the present invention.

Fig. 8 is outline sectional views representing one example of a typical semiconductor device, wherein Fig. 8A illustrates an intermediate device, and Fig. 8B illustrates a final device.

Fig. 9 is an outline sectional view representing another embodiment of a semiconductor device involving the present invention.

Fig. 10 is an outline sectional view representing another example of a typical semiconductor device.

Fig. 11 is an outline sectional view representing still another example of a semiconductor device involving the present invention.

### DETAILED DESCRIPTION OF THE INVENTION

### Embodiment Mode 1

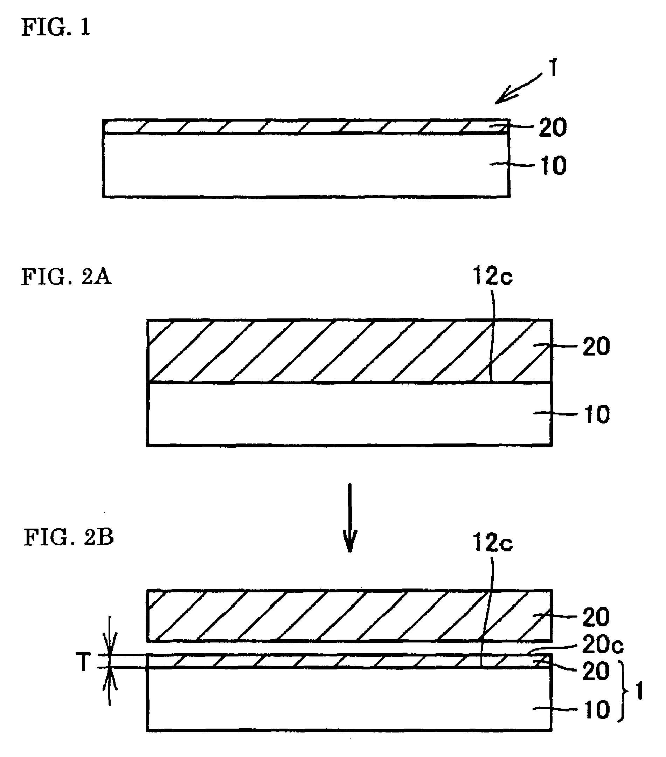

Referring to Fig. 1, one embodiment of the III-V nitride semiconductor layer-bonded substrate involving the present invention is a III-V nitride semiconductor layer-bonded substrate 1 in which a III-V nitride semiconductor layer 20 and a base substrate 10 are bonded together, the bonded substrate 1 being characterized in that a difference |α*_{L}* - *αₛ*| between the thermal expansion coefficient *α_{L}* of the III-V nitride semiconductor layer 20 and the thermal expansion coefficient *α_{S}* of the base substrate 10 is 4.5 × 10⁻⁶ K⁻¹ or less, and the thermal conductivity *λ_{S}* of the base substrate 10 is 50 W · m⁻¹ · K⁻¹ or more.

The situation in which the difference |α*_{L}* -α*ₛ* | between the thermal expansion coefficient α*_{L}* of the III-V nitride semiconductor layer 20 and the thermal expansion coefficient α*_{S}* of the base substrate 10 has gone higher than 4.5 x 10⁻⁶ K⁻¹ causes exfoliation of the III-V nitride semiconductor layer 20 bonded to the base substrate 10, and/or produces cracks in the III-V nitride semiconductor layer 20. From this perspective, the difference |α*_{L} -αₛ* I between the thermal expansion coefficient *α _{L}* of the III-V nitride semiconductor layer 20 and the thermal expansion coefficient α*_{S}* of the base substrate 10 is preferably 3.5 × 10⁻⁶ K⁻¹ or less, with 3.0 × 10⁻⁶ K⁻¹ or less being more preferable.

Furthermore, in the situation in which the thermal conductivity *λs* of the base substrate 10 is less than 50 W · m⁻¹ · K⁻¹, an accumulation of heat in III-V nitride semiconductor layer during manufacturing and operation of a semiconductor device increases, degrading the semiconductor device properties. From this perspective, the base substrate thermal conductivity *λ*_{S} is preferably 70 W · m⁻¹ · K⁻¹ or more, with at least 100 W · m⁻¹ · K⁻¹ being more preferable.

The III-V nitride semiconductor layer 20 in the III-V nitride semiconductor layer-bonded substrate 1 of Embodiment Mode 1 is not particularly limited, so the III-V nitride semiconductor layer 20 may be , to cite exemplary substrates, different Al_{1-*x-y*}Ga*ₓ*In*_{y}*N layers (0 ≤ *x*, 0 ≤ *y*, *x + y* ≤ 1). In particular, from the perspective of having outstanding versatility to various semiconductor devices, the III-V nitride semiconductor layer 20 is preferably a GaN layer.

The base substrate 10 in the III-V nitride semiconductor layer-bonded substrate 1 of Embodiment Mode 1 is not particularly limited, as long as the thermal expansion coefficient difference |α*_{L}*-α*_{S}*|between the III-V nitride semiconductor layer 20 and the base substrate 10 is 4.5 × 10⁻⁶ K⁻¹ or less, and the thermal conductivity *λs* of is 50 W · m⁻¹ · K⁻¹ or more. Referring to Table I, examples of substances preferably employed in the base substrate 10 include: single crystals, such as SiC, AlN, Si, GaN, GaP, ZrB₂ and InP; ceramic, such as polycrystalline AlN (poly-AlN), (sintered) BeO and (sintered) SiC; metals, such as W, Mo, Ir, Ta, and Nb; and heat sink material, such as (sintered) AlN, Cu-Mo alloys, Cu-W alloys, (sintered) Al-SiC composite materials, diamond, and (sintered) diamond-metal composite materials. Herein, the thermal expansion coefficients, heat conductivities, and resistivities of these substances are set forth in Table I.

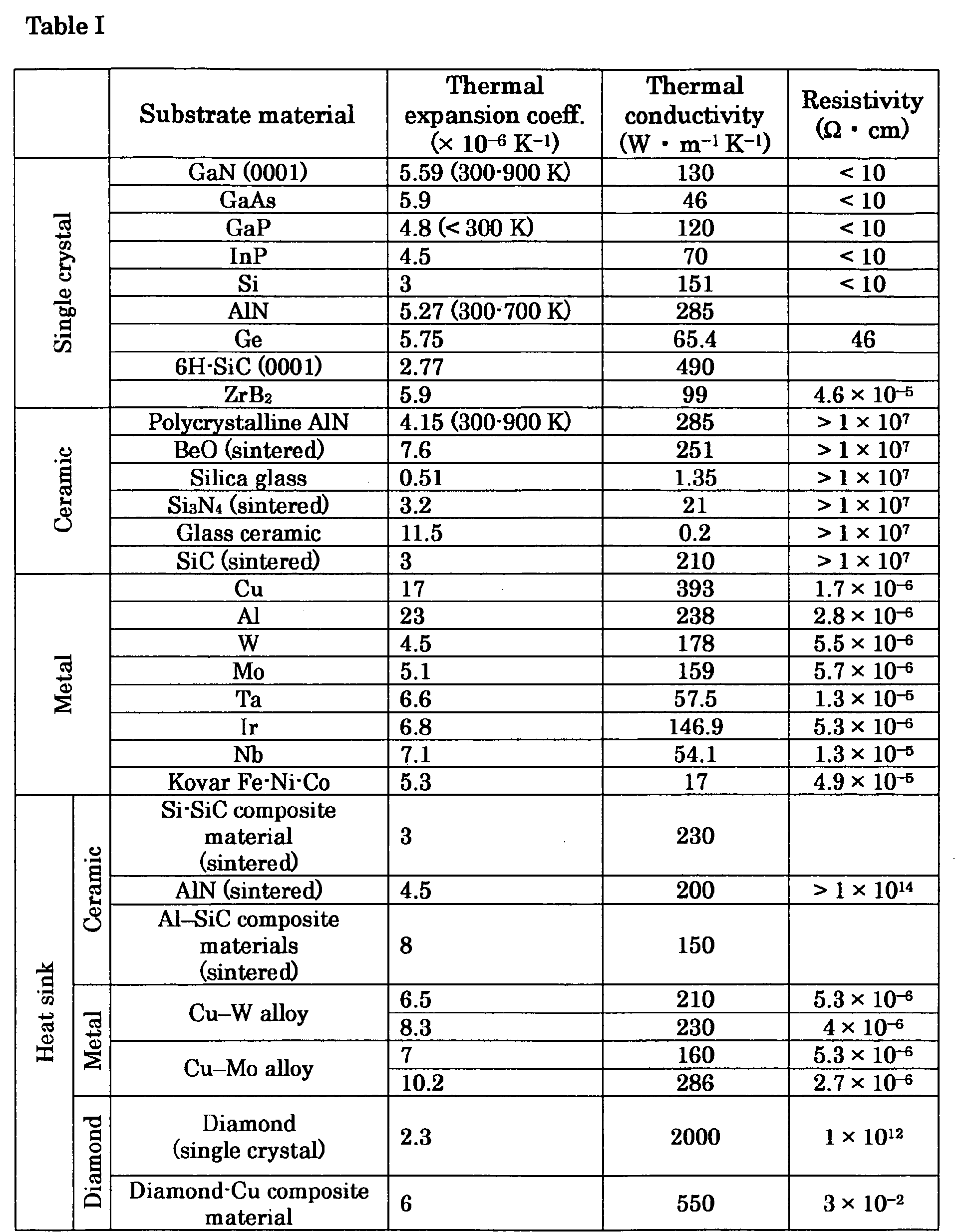

From the perspective of making it possible to form an electroconductive semiconductor device, either of the two principal surfaces of which an electrode can be formed, the resistivity of the base substrate 10 in the III-V nitride semiconductor layer-bonded substrate 1 of Embodiment Mode 1 is preferably 10 Ω · cm or less, with 1 Ω · cm or less being more preferable.

Furthermore, the base substrate 10 in the III-V nitride semiconductor layer-bonded substrate 1 of Embodiment Mode 1 is preferably composed mainly of a metal containing at least one of Mo, W, or Ir. Herein, the main component means a component contained 50 mol % or more in base substrate. Moreover, 99 mol % or more of a metal including at least either Mo, W, or Ir is preferably contained in the base substrate 10. Metallic Mo, metallic W and metallic Ir are each characterized by only slightly differing in thermal expansion coefficient from III-V nitride semiconductor, particularly from GaN, and by exhibiting high thermal conductivity and low resistivity. Metallic Mo is readily available and easily workable; meanwhile, although metallic W is not easy to work, it is readily available, and conversely, metallic Ir is not easy to come by yet is easily workable.

Also the base substrate 10 in the III-V nitride semiconductor layer-bonded substrate 1 of Embodiment Mode 1 is preferably composed mainly of at least one of AlN, Si, or SiC. That is, at least one of AlN, Si, or Sic is preferably contained 50 mol % or more in the base substrate 10. Additionally, in the base substrate 10, at least one of AlN, Si, or SiC is preferably contained 99 mol % or more. AlN, Si, and SiC are each characterized by only slightly differing in thermal expansion coefficient from III-V nitride semiconductors, particularly from GaN, and by exhibiting high thermal conductivity

Moreover, the thermal conductivity of the base substrate 10 in the III-V nitride semiconductor-bonded substrate 1 of Embodiment Mode 1 preferably equals or exceeds that of the III-V nitride semiconductor layer 20. In the situation in which the thermal conductivity *λ*_{S} of the base substrate 10 equals or exceeds the thermal conductivity λ*_{L}* of the III-V nitride semiconductor layer 20 (that is, λ_{S} ≥ λ*_{L}*), the base substrate 10 acts as a heat sink for the III-V nitride semiconductor layer 20, meaning that an accumulation of heat in the III-V nitride semiconductor layer 20 during manufacturing and operation of a device is reduced, the device properties are kept at a high level, and its useful life is extended.

Furthermore, the base substrate 10 in the III-V nitride semiconductor layer-bonded substrate 1 of Embodiment Mode 1 preferably includes at least one material selected from the group consisting of (sintered) AlN, Cu-Mo alloys, Cu-W alloys, (sintered) Al-SiC composite materials, diamond, or diamond-metal composite materials. These substances are especially advantageous for heat-sink material because they differ only slightly in thermal expansion coefficient from III-V nitride semiconductors, particularly from GaN, and exhibit remarkably high thermal conductivity

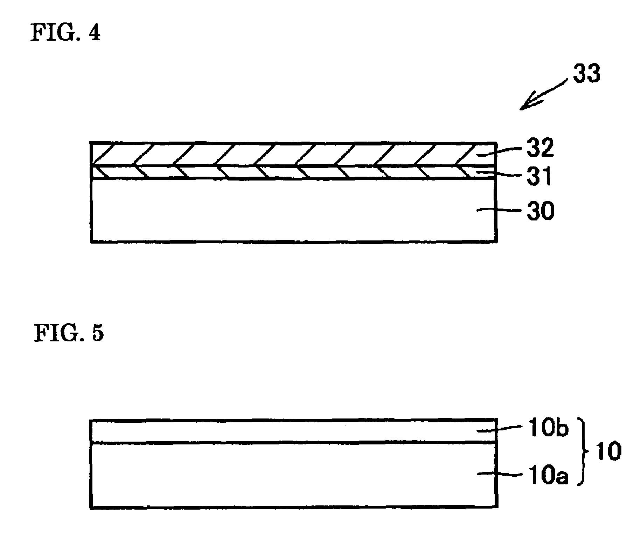

Additionally, referring to Fig. 5, in the base substrate 10 in the III-V nitride semiconductor layer-bonded substrate 1 of the present embodiment mode, a plurality of layers-for example, a first layer 10*a* and a second layer 10*b*-may be laminated. Constituting base substrate with a plurality of layers makes it possible to alter the base substrate properties. For example, in the base substrate 10 illustrated in Fig. 5, even with the first layer 10*a* being a substrate of low thermal conductivity, providing as the second layer 10*b* a thin film of high thermal conductivity yields a base substrate 10 whose thermal conductivity is heightened. Herein, the method whereby the plurality of layers is laminated is not particularly limited, with deposition techniques such as sputtering or MOCVD being utilized.

How to manufacture the III-V nitride semiconductor layer-bonded substrate involving the present invention is not particularly limited, but the following two embodiment modes, for example, are preferably utilized.

Referring to Figs. 2A and 2B, one of the two embodiment modes of the method of manufacturing the III-V nitride semiconductor layer-bonded substrate involving the present invention includes: a step (bonding step) of bonding together, as illustrated in Fig. 2A, one of principal faces of the thick III-V nitride semiconductor layer 20 and one of principal faces of the base substrate 10; and a step (separating step) of slicing away, as illustrated in Fig. 2B, the III-V nitride semiconductor layer 20 along a plane 20c, located at a distance *T* into the nitride semiconductor layer 20 from the plane 12*c* in which the nitride semiconductor layer 20 and the base substrate 10 are bonded together, and parallel to the bonding plane. These steps yield a substrate (III-V nitride semiconductor layer-bonded substrate 1) in which a thickness *T* of the III-V nitride substrate layer 20 has been bonded onto the base substrate 10.

Herein, the method whereby one of the principal surfaces of the thick III-V nitride semiconductor layer 20 and one of the principal surfaces of the base substrate 10 are bonded together is not particularly limited, but the following ways are preferably employed: the direct bonding technique in which the surfaces to be bonded together are cleaned, directly bonded together, and then joined at a raised temperatures of 600°C to 1200°C; and the surface activation technique in which the bonding plane is activated with plasma or ions to join the surfaces.

Herein, the technique whereby the III-V nitride semiconductor layer 20 is sliced in the plane 20*c* parallel to the bonding plane 12c and located at the distance *T* into the III-V nitride semiconductor layer 20 from the bonding plane is not particularly limited; accordingly, the III-V nitride semiconductor layer 20 can be mechanically cut by using an inner-circumferentially bladed slicer, an outer-circumferentially bladed slicer or handsaw, or by irradiating laser. Mechanically cutting the III-V nitride semiconductor layer 20, however, reduces the chances that the thickness Tof the III-V nitride semiconductor layer 20 on the base substrate 10 is brought to 10 µm or less, so that such a mechanical cutting way is generally suited to manufacturing of III-V nitride semiconductor layer-bonded substrate 1 in which a thickness of the III-V nitride semiconductor layer 20 is more than 10 µm.

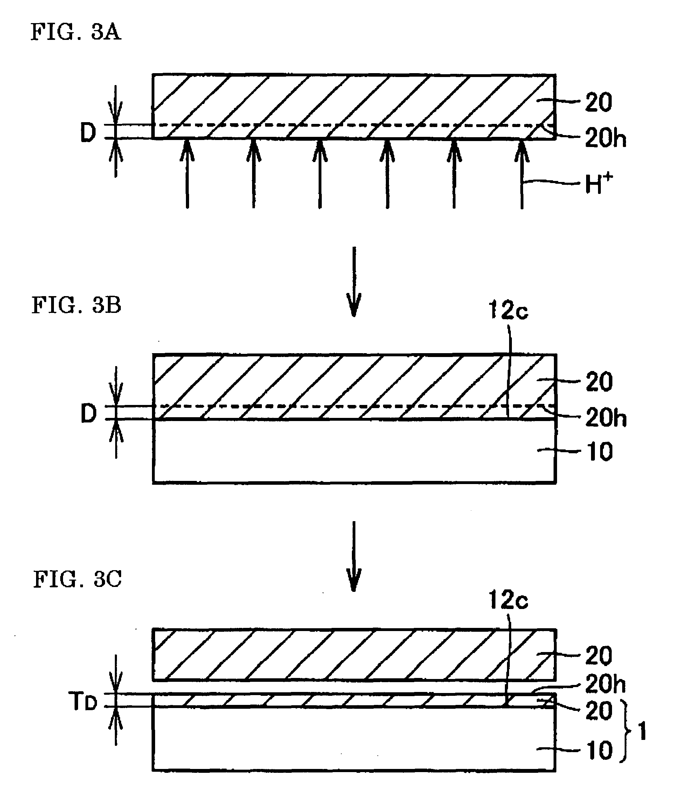

Referring to Figs. 3A to 3C, the other of the embodiment modes of the method of manufacturing the III-V nitride semiconductor layer-bonded substrate involving the present invention includes: a step (ion implanting step) of implanting, as illustrated in Fig. 3A, hydrogen, helium, nitrogen, oxygen, or other ions in a plane 20*h* at depth of *D* through one of the principal surfaces of the thick III-V nitride semiconductor layer 20; a step (bonding step) of bonding together, as illustrated in Fig. 3B, that principal surface of the III-V nitride semiconductor layer 20 through which the ions are implanted and one of the principal surfaces of the base substrate 10; and a step (separating step) of applying force, as illustrated in Fig. 3C, to the base substrate 10 and III-V nitride semiconductor layer 20 to separate off a remainder of the III-V nitride semiconductor layer 20 at a plane 20*h* at depth of *D,* of the III-V nitride semiconductor layer 20m, the depth *D* being seen from the bonding plane 12c.

Through above steps, the substrate (III-V nitride semiconductor layer-bonded substrate 1) in which a transferred part with thickness of *T_{D},* of the III-V nitride semiconductor layer 20 has been bonded to the base substrate 10 can be produced. Herein, the thickness *T_{D}* of the transferred part of the III-V nitride semiconductor layer 20 approximately equals the depth *D* at which the ions are implanted. Furthermore, in the ion implanting step, from the perspective of minimizing damage to substrate, an ion whose radius is small is preferable, with a hydrogen ion being most preferable. Additionally, in the separating step, the force applied to the base substrate 10 and III-V nitride semiconductor layer 20 includes not only direct force but also indirect force such as stress generated by heat processing.

Such a manufacturing method exploits the fact that that portion of III-V nitride semiconductor layer in which ions are implanted is made fragile, and the depth *D* at which the ions are implanted is precisely adjustable. For this reason, this method is suited to manufacturing of the III-V nitride semiconductor layer-bonded substrate 1 having the III-V nitride semiconductor layer 20 with the small thickness *T_{D}* of, for example, a level of 10 nm to 10µm.

Also in the situation in which a plurality of layers-for example, the first layer 10*a* and second layer 10*b*-are laminated as illustrated in Fig. 5 in the base substrate 10, the III-V nitride semiconductor-bonded substrate 1 of Embodiment Mode 1 can be produced in the same manner as represented in Figs. 2A, 2B and 3A to 3C.

### Embodiment Mode 2

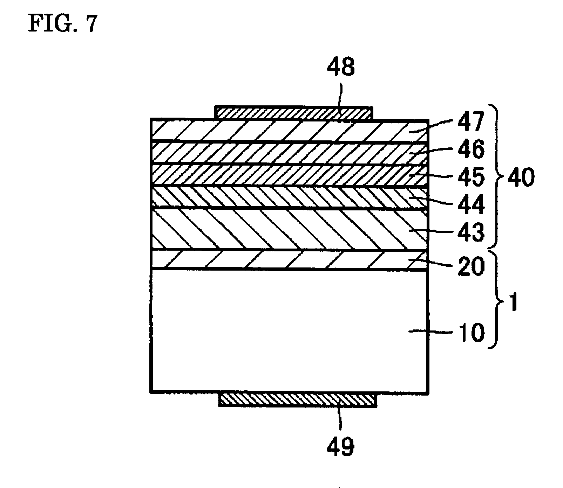

Referring to Fig. 7, one embodiment mode of the semiconductor device involving the present invention has an at least single-laminar III-V nitride semiconductor epitaxial layer 40 that has been formed on the III-V nitride semiconductor layer-bonded substrate 1 of Embodiment Mode 1. Because the III-V nitride semiconductor epitaxial layer 40 that has been formed on the III-V nitride semiconductor layer 20 bonded onto the base substrate 10 in the III-V nitride semiconductor layer-bonded substrate 1 exhibits enhanced crystallinity, semiconductor devices of satisfactory properties can be yielded.

Specifically, in the semiconductor device of Embodiment Mode 2, referring to Fig. 7, as the at least single-lamina III-V nitride semiconductor epitaxial layer 40, the following layers are formed on the III-V nitride semiconductor layer 20 in the III-V nitride semiconductor layer-bonded substrate 1: an *n*-type GaN layer 43; an *n*-type Al_{0.05}Ga_{0.95}N layer 44; an emission layer 45 having a multiple quantum well structure composed of an In_{0.2}Ga_{0.8}N layer and of a Al_{0.01}Ga_{0.99}N layer; a *p*-type Al_{0.2}Ga_{0.8}N layer 46; and a *p*-type GaN layer 47. How to form the III-V nitride semiconductor epitaxial layer 40 is not particularly limited, but from the perspective of making it possible to form satisfactory epitaxial layer, MOCVD or MBE are preferably utilized.

Furthermore, a *p*-side electrode 48 is formed on the *p*-type GaN layer 47, and an *n*-side electrode 49 on the base substrate 10 in the III-V nitride semiconductor layer-bonded substrate 1. In this way, in a semiconductor device of the present embodiment mode, the *p*-side electrode 48 and the *n*-side electrode 49 sandwich the III-V nitride semiconductor layer-bonded substrate 1 and the at least single-lamina III-V nitride semiconductor epitaxial layer 40 and are formed on the principal surfaces on both sides of the bonded substrate/epitaxial layer. Consequently, the base substrate 10 must be a metallic, semiconducting, etc., electroconductive substrate.

### Embodiment Mode 3

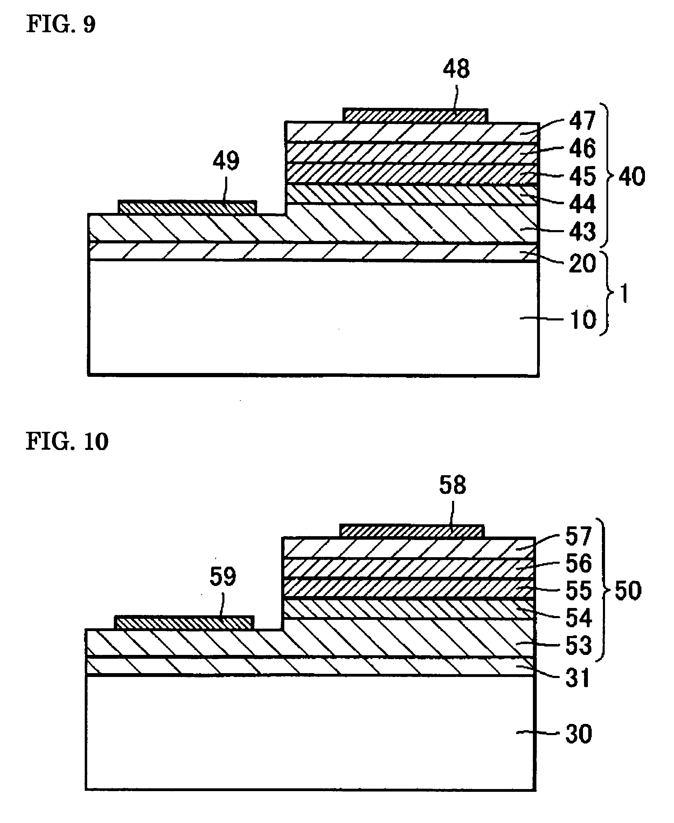

Referring to Fig. 9, another embodiment mode of the semiconductor device involving the present invention has an at least single-lamina III-V nitride semiconductor epitaxial layer 40 that has been formed on the III-V nitride semiconductor layer-bonded substrate 1 of Embodiment Mode 1. Because the III-V nitride semiconductor epitaxial layer 40 that has been formed on the III-V nitride semiconductor layer 20 bonded onto the base substrate 10 in the III-V nitride semiconductor layer-bonded substrate 1 exhibits superior crystallinity, semiconductor devices of enhanced properties can be obtained.

Specifically, in the semiconductor device of Embodiment mode 3, referring to Fig. 9, as the at least single-lamina III-V nitride semiconductor epitaxial layer 40, the following layers are formed on the III-V nitride semiconductor layer 20 in the III-V nitride semiconductor layer-bonded substrate 1: a *n*-type GaN layer 43; an *n*-type Al_{0.05}Ga_{0.95}N layer 44; an emission layer 45 having a multiple quantum well structure composed of a In_{0.2}Ga_{0.8}N layer and of a Al_{0.01}Ga_{0.99}N layer; *p*-type Al_{0.2}Ga_{0.8}N layer 46; and a *p*-type GaN layer 47. How to form the III-V nitride semiconductor epitaxial layer 40 is not particularly limited, but from the perspective of making it possible to form satisfactory epitaxial layer, MOCVD or MBE are preferably utilized.

Furthermore, a *p*-side electrode 48 is formed on the *p*-type GaN layer 47. On the other hand, an *n*-side electrode 49 is formed on the *n*-type GaN layer 43 where it has been exposed by dry-etching removal of respective partial regions of the *p*-type GaN layer 47, *p*-type Al_{0.2}Ga_{0.8}N layer 46, emission layer 45, and *n*-type Al_{0.05}Ga_{0.95}N layer 44.

### Embodiments

### Embodiment 1

In Embodiment 1, as to various kinds of base substrates and III-V nitride semiconductor layers, whether or not a base substrate principal surface and a semiconductor layer principal surface (elemental Group III-atomic surface) can be bonded together was checked. Herein, as the base substrates, Mo, W, Cu, Al, polycrystalline AlN, Si, SiC, and glass ceramic were utilized. And, as the III-V nitride semiconductor layers, five types of Al_{1-*x*}Ga*ₓ*N layers (*x* = 0, 0.25, 0.5, 0.75, and 1) were utilized.

First, in the following manner, the different III-V nitride semiconductor layers were formed. An AlN buffer layer 50 nm in thickness was formed by MOCVD, and then the five types of 2 µm-thick Al_{1-*x*}Ga*ₓ*N layers (*x* = 0, 0.25, 0.5, 0.75, and 1) were epitaxially grown, respectively on 2 inch (50.8 mm)-diameter, 400 µm-thick Si substrates. Subsequently, hydrogen ions were implanted in these five types of Al_{1-*x*}Ga*ₓ*N layers. With hydrogen ion accelerating voltage being 50 keV, and with the hydrogen ion implantation dose being 1 x 10¹⁷ cm⁻², a dopant maximum depth of approximately 200 nm below the Al_{1-*x*}Ga*ₓ*N layer principal surfaces (elemental III-atomic surfaces) was obtained.

After the hydrogen ion implantation, the Al_{1-*x*}Ga*ₓ*N layer principal surfaces (the elemental III-atomic surfaces) were cleaned, put in a dry-etching device, and then rendered cleansed surfaces by the plasma generated by discharging electricity through N₂ gas. Herein, the conditions under which the Al_{1-*x*}Ga*ₓ*N layer principal surfaces (the elemental III-atomic surfaces) were dry-etched with N₂ gas were: RF power of 100 W; N₂ gas flow rate of 50 sccm (1 sccm is a unit indicating that the volume of a gas flowing for one minute in the normal state-that is, 1013 hPa and 273 K-is 1 cm³); and N₂ gas partial pressure of 13.3 Pa.

On the other hand, the Mo, W, Cu, and Al base substrate principal surfaces were rendered cleansed surfaces by plasma generated by discharging electricity through Ar gas. Herein, the conditions under which the base substrate principal surfaces were dry-etched with Ar gas were: RF power of 100 W; Ar gas flow rate of 50 seem; and Ar gas partial pressure of 6.7 Pa. In addition, the AlN, Si, SiC and grass ceramic base substrate principal surfaces were rendered cleansed surfaces by plasma generated by discharging electricity through O₂ gas. Herein, the conditions under which the base substrate principal surfaces were dry-etched with O₂ gas were: RF power of 100 W; O₂ gas flow rate of 50 sccm; and O₂ gas partial pressure of 6.7 Pa.

Next, the Al_{1-*x*}Ga*ₓ*N layer principal surfaces (elemental III-atomic surfaces) and base substrate principal surfaces that had been cleansed by dry etching were bonded together in the open air. After bonding, being low in bonding strength, the principal surfaces were heated slowly from room temperature (for example, 20°C to 30°C) up to 200°C to 300°C over a period of 3 hours in the open air to increase bonding strength.

Subsequently, by ramping to 500°C and applying a load obliquely to the laminate wafers comprising base substrate, Al_{1-*x*}Ga*ₓ*N layers, AlN buffer layer, and Si substrate, the portion made fragile by the hydrogen ion implantation were separated out to form 200 nm-thick Al_{1-*x*}Ga*ₓ*N layers onto the base substrates. Under this test, those laminate wafers yielding a bonded substrate were defined as passing, and those in which, under heat, an Al_{1-*x*}Ga*ₓ*N layer was exfoliated from the base substrate or cracks were produced in an Al_{1-*x*}Ga*ₓ*N layer were defined as failing. The results are set forth in Table II.

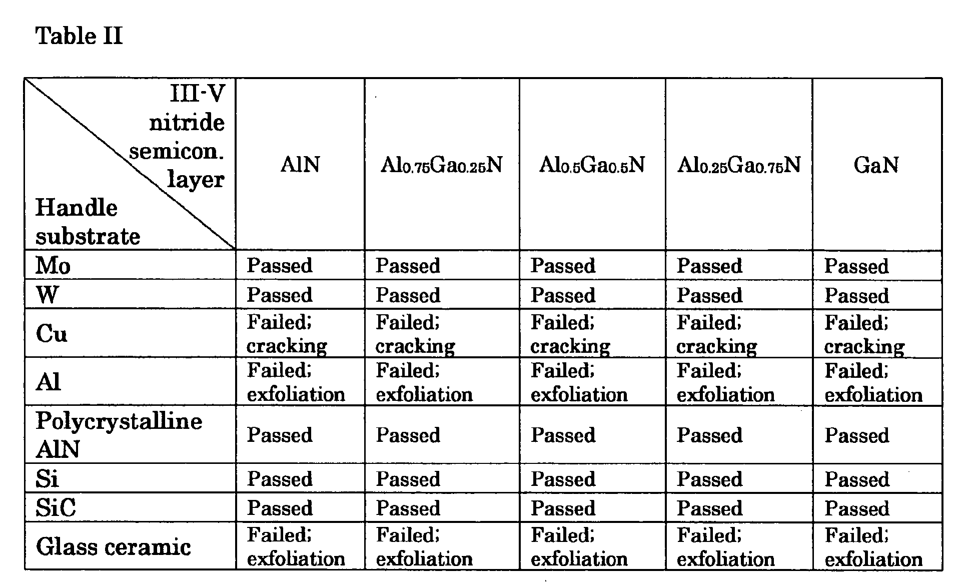

As is clear from Table II, all the five kinds of Al_{1-*x*}Ga*ₓ*N layers (*x* = 0, 0.25, 0.5, 0.75 and 1) could be bonded to the Mo, W, polycrystalline AlN, Si, and SiC base substrates, but could not be bonded to the Cu, Al, and glass ceramic substrates. Herein, the base substrates and III-V nitride semiconductor layers that were successfully bonded together met the relationship: the difference in thermal expansion coefficient was 4.5 × 10⁻⁶ K⁻¹ or less; and the base substrate thermal conductivity was 50 W · m⁻¹ · K⁻¹ or more.

### Embodiment 2

In Embodiment 2, it was checked whether or not principal surfaces of different base substrates and principal surface of a GaN layer (III-V nitride semiconductor layer) could be bonded together. Herein, as the base substrates, Mo, W, Cu, Al, polycrystalline AlN, Si, SiC, glass ceramic, Cu-Mo alloys, Cu-W alloys, (sintered) Al-SiC composite materials, and (sintered) diamond-Cu composite material were utilized.

Although the thermal expansion coefficient and thermal conductivity of the Cu-Mo alloy, Cu-W alloy, Al-SiC composite materials, and diamond-Cu composite material that were utilized as the base substrates varied depending on content of the components, Cu-Mo alloys with thermal expansion coefficient of 8 x 10⁻⁶ K⁻¹ and thermal conductivity of 180 W · m⁻¹ · K⁻¹, Cu-W alloys with thermal expansion coefficient of 8 x 10⁻⁶K⁻¹ and thermal conductivity of 230 W · m⁻¹ · K⁻¹, Al-SiC composite materials with thermal expansion coefficient of 8 × 10⁻⁶ K⁻¹ and thermal conductivity of 150 W · m⁻¹ · K⁻¹, and diamond-Cu composite material with thermal expansion coefficient of 6 x 10⁻⁶ K⁻¹ and thermal conductivity of 550 W · m⁻¹ · K⁻¹ were employed in Embodiment 2.

Referring to Fig. 3A, as material for forming the GaN layer, a 2 inch (50.8 mm)-diameter, 500 µm-thick GaN wafer (III-V nitride semiconductor layer 20) doped with oxygen was prepared, with the principal faces on either side of the wafer being specular-polished. This GaN wafer is hexagonal crystal, whose (0001) faces are the wafer principal surfaces. This GaN wafer (III-V nitride semiconductor layer 20) has the resistivity of 1 Ω · cm or less, and a carrier concentration of 1 x 10¹⁷ cm⁻³ or more. Hydrogen ions were implanted in the GaN wafer (III-V nitride semiconductor layer 20). With hydrogen ion accelerating voltage being 50 keV, and with hydrogen ion implantation dose being 7 × 10¹⁷ cm⁻², a dopant maximum depth of approximately 200 nm below one (N-atomic surface) of the GaN wafer principal surfaces was obtained.

After the hydrogen ion implantation, one of the GaN layer principal surface (N-atomic surface) was cleaned, put in a dry-etching device, and then rendered a cleansed surface by plasma generated by discharging electricity through N₂ gas. Herein, the conditions under which the GaN layer principal surface (N-atomic surface) was dry-etched with N₂ gas were: RF power of 100 W; N₂ gas flow rate of 50 seem; and N₂ gas partial pressure of 13.3 Pa.

On the other hand, principal surfaces of the Mo, W, Cu, Al, Cu-Mo alloy, Cu-W alloy, Al-SiC composite materials, or diamond-Cu composite material base substrates were rendered cleansed surfaces by plasma generated by discharging electricity through Ar gas. Herein, the conditions under which the base substrate principal surfaces were dry-etched with Ar gas were: RF power of 100 W; Ar gas flow rate of 50 sccm; and Ar gas partial pressure of 6.7 Pa. Furthermore, the principal surfaces of the polycrystalline AlN, Si, SiC, and grass ceramic base substrates were rendered cleansed surfaces by plasma generated by discharging electricity through O₂ gas. Herein, the conditions under which the base substrate principal surfaces were etched with O₂ gas were: RF power of 100 W; O₂ gas flow rate of 50 sccm; and O₂ gas partial pressure of 6.7 Pa.

Next, referring to Fig. 3B, the principal surface (N face) of the GaN wafer (III-V nitride semiconductor layer 20) and base substrate principal surfaces that have been cleansed by dry etching were bonded together in the open air. Herein, for Mo, W, Cu, Al, AlN, Si, SiC, and glass ceramic base substrates, pressure during the bonding was made 7 MPa (1400 kgf/2-inch wafer). Furthermore, for the Cu-Mo alloy, Cu-W alloy, Al-SiC composite materials, and diamond-Cu composite material base substrates, the pressure during the bonding was brought to 15 MPa (3000 kgf/2-inch wafer). After bonded, being low in bonding strength, the GaN wafer principal surface and base substrate principal surfaces were heated slow from room temperature (for example, 20°C - 30°C) to 200°C - 300°C over a period of three hours in the open air to increase the bonding strength.

Subsequently, by ramping to 500°C and applying a load obliquely to the laminate wafers comprising base substrate and GaN layer, the portion made fragile by the hydrogen ion implantation were separated out to form 200 nm-thick GaN layers (III-V nitride semiconductor layers 20) onto the base substrates 10. Under this test, those laminate wafers yielding a bonded substrate were defined as passing, and those in which, under heat, the GaN layer was exfoliated from the base substrate or cracks were produced in the GaN layer were defined as failing. The results are set forth in Table III.

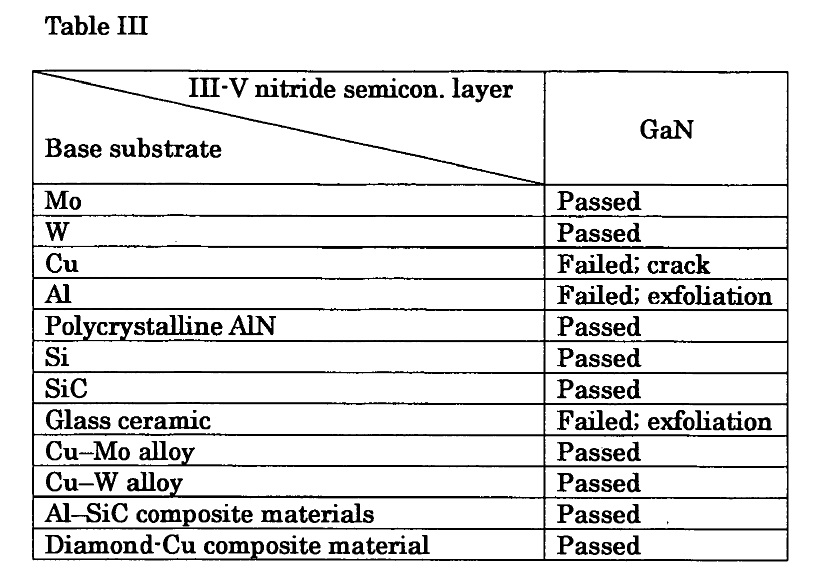

As clear from Table III, the Mo, W, polycrystalline AlN, Si, SiC, Cu-Mo alloy, Cu-W alloy, Al-SiC composite materials, and diamond-Cu composite material base substrates could be bonded with a GaN layer, but the Cu, Al, and glass-ceramic base substrates could not be bonded with a GaN layer. Herein, the successfully bonded base substrates and III-V nitride semiconductor layers met the relationship: the difference in thermal expansion coefficient was 4.5 x 10⁻⁶ K⁻¹ or less, and the base substrate thermal conductivity was 50 W · m⁻¹ · K⁻¹ or more.

### Embodiment 3

Referring to Fig.4, a 50 nm-thick AlN buffer layer (III-V nitride buffer layer 31) and a 200 nm-thick GaN epitaxial layer (III-V nitride epitaxial layer 32) were formed by MOCVD on a sapphire substrate (the base substrate 30) to create a GaN epitaxial substrate (substrate 33 with III-V nitride epitaxial layer). Also the following substrates were prepared: the bonded substrate (GaN layer/Mo bonded substrate), created in Embodiment 2, in which a Mo substrate (base substrate) and a 200 nm-thick GaN substrate were bonded together; and a bonded substrate (GaN layer/Si bonded substrate) in which a Si substrate (base substrate) and a 200 nm-thick GaN layer were bonded together.

The substrate with an attached GaN epitaxial layer, the GaN layer/Mo bonded substrate, and the GaN layer/Si bonded substrate were each immersed into an aqueous NaOH solution at 180°C to measure the density of etch pits arising in correspondence with the GaN layer or GaN epitaxial layer dislocation density. The etch pit density in the GaN layers in the GaN layer/Mo bonded substrate and GaN layer/Si bonded substrate was under one sixth that of the GaN epitaxial layer in the substrate with an attached GaN epitaxial layer. The foregoing results demonstrated that the GaN layers in the GaN layer-bonded substrates had a dislocation density lower than that of the GaN epitaxial layer in the substrate with an attached GaN epitaxial layer.

### Embodiment 4

Referring to Fig. 7, on the GaN layer (III-V nitride semiconductor layer 20) in the bonded substrate (GaN layer/Mo bonded substrate), produced in Embodiment 2, in which the Mo substrate (base substrate 10) and the 200 nm-thick GaN layer (III-V nitride semiconductor layer 20) had been bonded together, the following layers were formed by MOCVD as the III-V nitride semiconductor epitaxial layer 40: a 2 µm-thick *n*-type GaN layer 43; a 0.5 µm-thick *n*-type Al_{0.05}Ga_{0.95}N layer 44; a 100 nm-thick emission layer 45 having a multiple quantum well structure composed of six pairs of In_{0.2}Ga_{0.8}N layers and Al_{0.01}Ga_{0.99}N layers; a 20 nm-thick *p*-type Al_{0.2}Ga_{0.8}N layer 46; and a 0.15 µm-thick *p*-type GaN layer 47. Subsequently, a *p*-side electrode 48 was formed on the *p*-type GaN layer 47, and an *n*-side electrode 49 on the Mo substrate (base substrate 10), by vacuum deposition technique or by electron beam evaporation technique to create a semiconductor device LED-4A.

Additionally, in the same manner as in above example, a semiconductor device LED-4B was created employing the bonded substrate, produced in Embodiment 2, in which the W substrate and 200 nm-thick GaN layer had been bonded together.

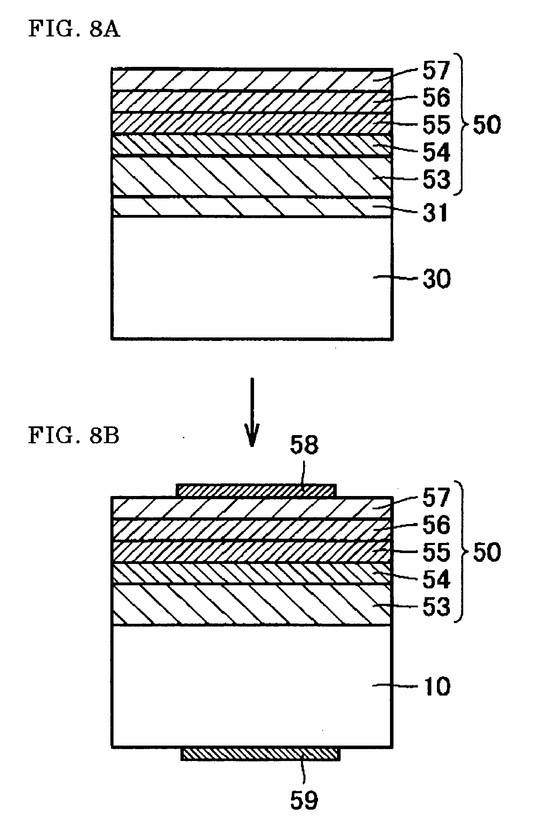

On the other hand, for comparison with above semiconductor devices, a typical semiconductor device LED-R1 was created in the manner in which, referring to Fig. 8A, a 50 nm-thick AlN buffer layer (III-V nitride buffer layer 31), and additionally, as a III-V nitride semiconductor epitaxial layer 50, a 2 µm-thick *n*-type GaN layer 53, a 0.5 µm-thick *n*-type Al_{0.05}Ga_{0.95}N layer 54, a 100 nm-thick emission layer 55 having a multiple quantum well structure composed of six pairs of In_{0.2}Ga_{0.8}N layers and Al_{0.01}Ga_{0.99}N layers, a 20 nm-thick *p*-type Al_{0.2}Ga_{0.8}N layer 56, and 0.15 µm-thick *p*-type GaN layer 57 were formed by MOCVD on a sapphire substrate (the base substrate 30).

Next, the p-type GaN layer 57, serving as a temporary substrate, was attached to a (not illustrated) Si substrate, and then the *n*-type GaN layer 53, exposed by removing the sapphire substrate (baseplate 30) utilizing a laser lift-off technique, was bonded (not illustrated) to the Mo substrate (base substrate 10) in the same manner as in Embodiment 2. After the bonding, the Si substrate serving as the temporary substrate was heated up to 200°C and removed (not illustrated).

Next, referring to Fig. 8B, a *p*-side electrode 58 was formed on the *p*-type GaN layer 57 and an *n*-side electrode 59 on the Mo substrate (base substrate 10) by vacuum deposition technique or by electron beam evaporation technique to create the semiconductor device LED-R1.

As a result of measuring emission intensities of the created LED-4A, LED-4B, and LED-R1 at peak wavelength of 450 nm, the emission intensities of the LED-4A and LED-4B was respectively 1.3 and 1.4 relative to the emission intensity of the LED-R1. That is, it has been proved that the III-V nitride semiconductor epitaxial layer 40 formed on the III-V nitride semiconductor layer of the III-V nitride semiconductor layer-bonded substrate has crystallnity and exhibits device characteristics superior to crystallinity and device characteristics of the III-V nitride semiconductor epitaxial layer 50 formed on the sapphire substrate with the buffer layer intervening between the substrate and the bonded substrate.

### Embodiment 5

Referring to Fig. 9, on the GaN layer (III-V nitride semiconductor layer 20) of the bonded substrate (GaN layer-polycrystalline AlN bonded substrate) that had been produced in Embodiment 2, and in which the polycrystalline AlN substrate (base substrate 10) and the 200 nm-thick GaN layer (III-V nitride semiconductor layer 20) had been bonded together, the following layers were formed as the III-V nitride semiconductor epitaxial layer by MOCVD: a 2 µm-thick *n*-type GaN layer 43; a 0.5 µm-thick *n*-type Al_{0.05}Ga_{0.95}N layer 44; a 100 nm-thick emission layer 45 having a multiple quantum well structure composed of six pairs of In_{0.2}Ga_{0.8}N layers and an Al_{0.01}Ga_{0.99}N layers; a 20 nm-thick *p*-type Al_{0.2}Ga_{0.8}N layer 46; and a 0.15 µm-thick *p*-type GaN layer 47.

Subsequently, partial regions of the p-type GaN layer, *p*-type Al_{0.2}Ga_{0.8}N layer 46, emission layer 45, and *n*-type Al_{0.05}Ga_{0.95}N layer 44 were removed by mesa-etching so that the *n*-type GaN layer 43 was regionally exposed. Successively, a *p*-side electrode 48 were formed on the *p*-type GaN layer 47 and a *n*-side electrode 49 on that region of the *n*-type GaN layer 43 which had been exposed by vacuum deposition technique or by electron beam evaporation technique to create a semiconductor device LED-5A.

Additionally, in the same manner as in above example, a semiconductor device LED-5B was created employing the bonded substrate (GaN layer-SiC bonded substrate) that had been produced in Embodiment 2, and in which the SiC substrate (base substrate) and the 200 nm-thick GaN layer had been bonded together.

On the other hand, for comparison with above semiconductor devices, a typical semiconductor device LED-R2 was created in the manner in which, referring to Fig. 10, a 50 nm-thick AlN buffer layer (III-V nitride buffer layer 31) first, and additionally, as the III-V nitride semiconductor epitaxial layer 50, a 2 µm-thick *n*-type GaN layer 53, a 0.5 µm-thick *n*-type Al_{0.05}Ga_{0.95}N layer 54, a 100 nm-thick emission layer 55 having a multiple quantum well structure composed of six pairs of In_{0.2}Ga_{0.8}N layers and Al_{0.01}Ga_{0.99}N layers, a 20 nm-thick *p*-type Al_{0.2}Ga_{0.8}N layer 56, and 0.15 µm-thick *p*-type GaN layer 57 were formed by MOCVD on a sapphire substrate (base substrate 30).

Next, a portion of the *p*-type GaN layer 57, *p*-type Al_{0.2}Ga_{0.8}N layer 56, emission layer 55, and *n*-type Al_{0.05}Ga_{0.95}N layer 54 was removed by mesa etching so that the *n*-type GaN layer 53 was regionally exposed. Subsequently, by vacuum deposition technique, or by electron beam evaporation technique, a *p*-side electrode 58 was formed on the *p*-type GaN layer 57, and an *n*-side electrode 59 on that region of the *n*-type GaN layer 43 which had been exposed, and thus a semiconductor device LED-R2 was created.

As a result of measuring emission intensities of the created LED-5A, LED-5B, and LED-R2 at peak wavelength of 450 nm, the emission intensities of the LED-5A and LED-5B were respectively 1.22 and 1.27 relative to the emission intensity of the LED-R2. That is, these results indicated that the III-V nitride semiconductor epitaxial layer 40 formed on the III-V nitride semiconductor layer of the III-V nitride semiconductor layer-bonded substrate had crystallnity and exhibited device properties superior to crystallinity and device properties of the III-V nitride semiconductor epitaxial layer 50 formed on the sapphire substrate (base substrate 30) with the III-V nitride buffer layer 31 intervening between the substrate and the bonded substrate.

### Embodiment 6

Referring to Fig. 5, a 10 µm-thick polycrystalline diamond layer (second layer 10*b*) was formed by hot-filament CVD on a 2 inch (50.8 mm)-diameter, 400 µm-thick Si substrate (first layer 10*a*). The conditions under which the polycrystalline diamond layer was formed were: H₂ gas flow rate of 1000 sccm (1 sccm means here flow rate of a gas flowing in the normal state-that is, 1013 hPa and 273 K-flowed for one minute was 1 cm³); CH₄ gas flow rate of 30 sccm; filament temperature of 2000°C; and pressure of 2.66 kPa (20 Torr). Successively, a substrate specular-polished by mechanically polishing the polycrystalline diamond layer (second layer 10*b*) surface with diamond abrasives was rendered the base substrate 1.

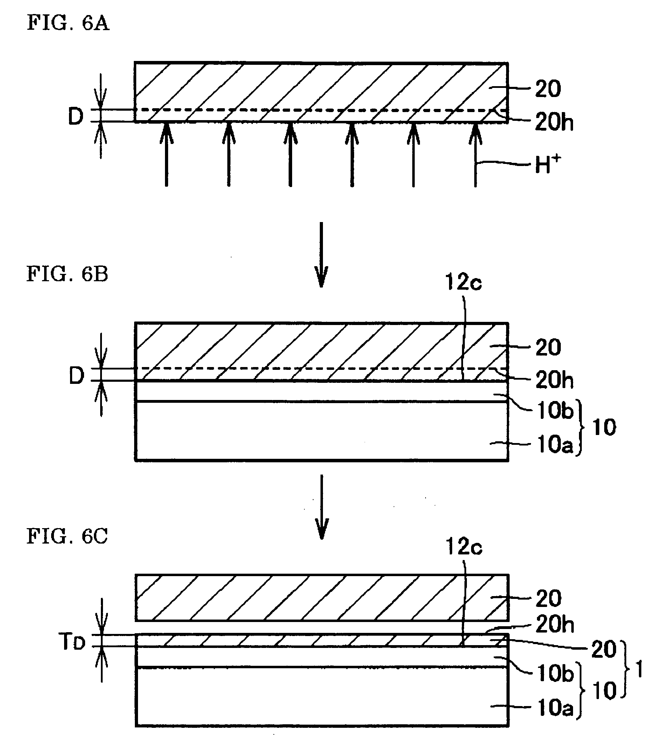

On the other hand, referring to Fig. 6A, in the same manner as in Embodiment 2, hydrogen ions were implanted in the GaN wafer (III-V nitride semiconductor layer 20) described in Embodiment 2. With the hydrogen ion implantation dose being 7 × 10¹⁷ cm⁻², a dopant maximum depth of approximately 200 nm below the GaN wafer principal surface (N-atomic surface) was obtained. After the hydrogen ion implantation, the GaN wafer principal surface (N-atomic surface) was cleaned, put in a dry-etching device, and then was rendered a cleansed surface by plasma generated by discharging electricity in N₂ gas. Herein, the conditions under which the GaN wafer principal surface (N-atomic surface) was dry-etched with N₂ gas were: RF power of 100 W; N₂ gas flow rate of 50 sccm, and N₂ gas partial pressure of 13.3 Pa.

Furthermore, referring to Fig. 5, the principal surface of the polycrystalline diamond layer (second layer 10*b*) of the base substrate 10 in which the polycrstalline diamond layer (second layer 10*b*) was formed on the Si substrate (first layer 10*a*) was rendered a cleansed surface by plasma generated by discharging electricity in Ar gas. Herein, the conditions in which the diamond layer (second layer 10*b*) of the base substrate 10 was dry-etched with Ar gas were; RF power of 100 W; Ar gas flow rate of 50 sccm; and Ar gas partial pressure of 6.7 Pa.

Next, referring to Fig. 6B, the principal surface (N-atomic surface) cleansed through dry etching of the GaN wafer (III-V nitride semiconductor layer 20) and the principal surface of the polycrystalline diamond layer (second layer 10*b*) in the base substrate 10 were bonded together in the open air. The pressure at which the bonding was carried out was made 15 Mpa (3000 kgf/2-inch wafer). After bonded, being low in bonding strength, the bonded base substrate 10 and GaN wafer (III-V nitride semiconductor layer 20) were heated slow from room temperature (for example, 20°C to 30°C) to 200°C to 300°C over a period of 3 hours in the open air to increase the bonding strength.

Moreover, referring to Fig. 6C, at raised temperature of 500°C, by applying load was obliquely to the wafer in which the base substrate 10 and the GaN layer (III-V nitride semiconductor layer 20) were laminated, that part of the GaN wafer (III-V nitride semiconductor layer 20) which had been made fragile by the hydrogen ion implantation was separated to produce the III-V nitride semiconductor layer-bonded substrate 1 in which the 200 nm-thick GaN layer (a transferred part of the III-V nitride semiconductor layer 20) had been bonded onto the base substrate 10.

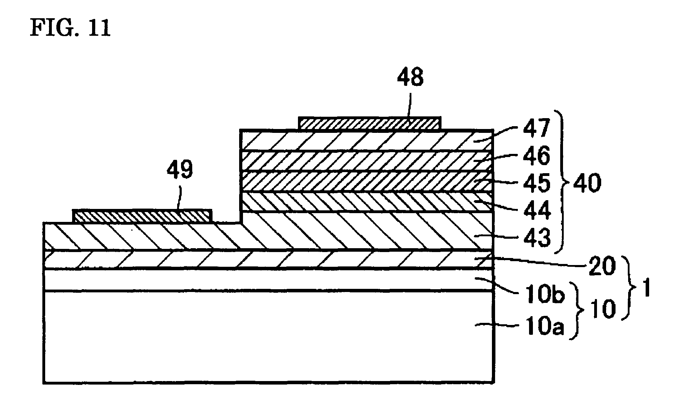

Next, referring to Fig. 11, on the GaN layer (the transferred part of the III-V nitride semiconductor layer 20) of the (GaN layer-polycrystalline diamond-Si substrate) III-V nitride semiconductor layer-bonded substrate 1 produced in the above manner, the following layers were formed by MOCVD as the III-V nitride semiconductor epitaxial layer 40: a 2 µm-thick, *n*-type GaN layer 43; a 0.5 µm-thick, *n*-type Al_{0.05}Ga_{0.95}N layer 44; a 100 nm-thick emission layer 45 having a multiple quantum well structure composed of six pairs of In_{0.2}Ga_{0.8}N layers and Al_{0.01}Ga_{0.99}N layers; a 20 nm-thick, *p*-type Al_{0.2}Ga_{0.8}N layer 46; and 0.15 µm-thick, *p*-type GaN layer 47.

Subsequently, a portion of the *p*-type GaN layer 47, *p*-type Al_{0.2}Ga_{0.8}N layer 46, emission layer 45, and *n*-type Al_{0.05}Ga_{0.95}N layer 44 was removed by mesa etching so that the *n*-type GaN layer 43 was regionally exposed. After that, by vacuum deposition technique, or by electron beam evaporation technique, a *p*-side electrode 48 was formed on the *p*-type GaN layer 47 and an *n*-side electrode 49 on that region of the *n*-type GaN layer 43 which had been exposed, to create a semiconductor device LED-6A.

As a result of measuring emission intensities of the LED-6A created in Embodiment 6 and of the comparative LED-R2 created in Embodiment 5 at peak wavelength of 450 nm, the emission intensity of the LED-6A was 1.16 relative to that of the LED-R2. That is, the result proved that the III-V nitride semiconductor epitaxial layer 40 formed on the III-V nitride semiconductor layer 20 of the III-V nitride semiconductor layer-bonded substrate 1 had crystallnity and exhibited device characteristics superior to crystallinity and device characteristics of the III-V nitride semiconductor epitaxial layer 50 formed on the sapphire substrate (base substrate 30) with the III-V nitride buffer layer 31 intervening between the substrate and the epitaxial layer.

The presently disclosed embodiments and implementation examples should in all respects be considered to be illustrative and not limiting. The scope of the present invention is set forth not by the foregoing description but by the scope of the patent claims, and is intended to include meanings equivalent to the scope of the patent claims and all modifications within the scope.

Only selected embodiments have been chosen to illustrate the present invention. To those skilled in the art, however, it will be apparent from the foregoing disclosure that various changes and modifications can be made herein without departing from the scope of the invention as defined in the appended claims. Furthermore, the foregoing description of the embodiments according to the present invention is provided for illustration only, and not for limiting the invention as defined by the appended claims and their equivalents.

## Claims

1. A III-V nitride semiconductor layer-bonded substrate in which a III-V nitride semiconductor layer and a base substrate are bonded together, **characterized in that**:
the difference in coefficient of thermal expansion between the III-V nitride semiconductor layer and the base substrate is 4.5 × 10⁻⁶ K⁻¹ or less; and
the thermal conductivity of the base substrate is 50 W · m⁻¹ · K⁻¹ or more.

2. A III-V nitride semiconductor layer-bonded substrate as set forth in claim 1, wherein the III-V nitride semiconductor layer is GaN layer.

3. A III-V nitride semiconductor layer-bonded substrate as set forth in claim 1 or claim 2, wherein the resistivity of the base substrate is 10 Ω · cm or less.

4. A III-V nitride semiconductor layer-bonded substrate as set forth in claim 1 or claim 2, wherein the principal component of the base substrate is a metal including at least whichever of Mo, W, or Ir.

5. A III-V nitride semiconductor layer-bonded substrate as set forth in claim 1 or claim 2, wherein the principal component of the base substrate is at least whichever of AlN, Si, or SiC.

6. A III-V nitride semiconductor layer-bonded substrate as set forth in claim 1 or claim 2, wherein the thermal conductivity of the base substrate equals or exceeds the thermal conductivity of the III-V nitride semiconductor layer.

7. A III-V nitride semiconductor layer-bonded substrate as set forth in claim 6, wherein the base substrate includes one material selected from the group consisting of Cu-Mo alloys, Cu-W alloys, Al-SiC composite materials, diamond, and diamond-metal composite materials.

8. A III-V nitride semiconductor layer-bonded substrate as set forth in claim 1 or claim 2, wherein a plurality of layers are laminated in the base substrate.

9. A semiconductor device having an at least single-lamina III-V nitride semiconductor epitaxial layer formed on a III-V nitride semiconductor layer-bonded substrate as set forth in claim 1 or claim 2.
